# EUROPEAN PATENT SPECIFICATION

(11) **EP 1 160 353 B1**
(45) Date of publication and mention of the grant of the patent: **12.12.2007**
(21) Application number: 00111028.7
(22) Date of filing: 31.05.2000
(51) Int. Cl.: C23C 16/36, C23C 30/00, C23C 16/02

(54) **Coated cemented carbide cutting tool member and process for producing the same**
Beschichtetes Schneidwerkzeug aus zementiertem Karbid und Verfahren zu dessen Herstellung
Outil de coupe en carbure fritté muni d'un revêtement et son procédé de fabrication

(43) Date of publication of application: 05.12.2001
(73) Proprietor: MITSUBISHI MATERIALS CORPORATION, Chiyoda-ku, Tokyo (JP)
(72) Inventor: Hirakawa, Yoshio, Mitsubishi Materials Corporation, Yuuki-gun, Ibaraki-ken (JP); Honma, Tetsuhiko, Mitsubishi Materials Corporation, Yuuki-gun, Ibaraki-ken (JP); Kunugi, Hitoshi, Mitsubishi Materials Corporation, Yuuki-gun, Ibaraki-ken (JP); Ueda, Toshihiko, Central Research, Saitama-ken (JP)
(74) Representative: HOFFMANN EITLE

(56) References cited:
- EP-A- 0 643 152
- US-A- 5 681 651
- US-A- 5 920 760
- PATENT ABSTRACTS OF JAPAN vol. 1996, no. 05, 31 May 1996 (1996-05-31) & JP 08 001412 A (NACHI FUJIKOSHI CORP), 9 January 1996 (1996-01-09)

## Description

### BACKGROUND OF THE INVENTION

### Field of the invention

The present invention relates to a coated cemented carbide cutting tool member (hereinafter referred as "coated carbide member") that resists breakage and chipping of its cutting edge for a long period of time, particularly when it is applied to cutting operations of extremely severe conditions such as high speed, high feed, thick depth-of-cut interrupted cutting of steels and cast irons because its hard coating layer includes improved titanium carbonitride layer having longitudinal crystal structure that has superior characteristics against chipping at cutting edge.

### Description of the Related Art

It is well known that coated carbide member is manufactured by depositing a hard coating layer, having an average thickness of 3 to 25 µm preferably comprise (a) at least one titanium compound layer having an average thickness of 0.1 to 5 µm and composed of at least one layer of granular titanium compound selected from titanium carbide (hereinafter referred to as "TiC"), titanium nitride (TiN), titanium carbonitride (TiCN), titanium oxide (Ti₂O₃), titanium carboxide (TiCO), titanium nitroxide (TiNO) and titanium carbonitroxide (TiCNO), (b) TiCN layer having longitudinal growth crystal structure (1-TiCN) with its average thickness of 2 to 15 µm, and (c) aluminum oxide (Al₂O₃) layer having an average thickness of 0.5 to 8 µm, on tungsten carbide-based cemented carbide substrate. The common technique for depositing said hard coating layer is CVD (Chemical Vapor Deposition) and/or PVD (Physical Vapor Deposition). It is also widely known that coated carbide member is widely used in various fields of cutting operations, for example, continuous and interrupted cutting operation of metal work pieces such as steels and cast irons.

Al₂O₃ layer have several different crystal polymorphs, among which the alpha-Al₂O₃ is known as thermodynamically the most stable polymorph having corundum structure, and typical polymorphs of Al₂O₃ layer used as hard coating layer are stable alpha-Al₂O₃ and meta-stable kappa-Al₂O₃. 1-TiCN layer is manufactured by CVD method at moderate temperature range such as 700 to 950°C using reaction gas mixture which includes organic cyanide compounds such as acetonitrile (CH₃CN), that was disclosed in Japanese Unexamined Patent Publication No.6-8010 and No.7-328808.

US 5,920,760 describes a coated hard alloy blade member comprising a WC-based cemented carbide substrate, and a hard coating deposited on said substrate. The hard coating includes an inner layer of TiCN having unilaterally grown crystals of an elongated shape, prepared by a two step deposition process wherein a first coating of TiCN is formed using a CVD gas for TiCN deposition comprising CH₃CN having a concentration of CH₃CN gas of from 0.01 to 0.1 vol.-% and a second coating of TiCN is formed using a CVD gas for TiCN deposition wherein the concentration of CH₃CN gas is increased to from 0.1 to 1.0 vol.-%, and an outer layer of Al₂O₃ having a crystal form of κ or κ+α wherein κ>α.

In recent years, there has been an increasing demand for laborsaving, less time consuming cutting operations. Accordingly, there is a tendency that the condition of cutting operation has changed to severe side, such as high speed, high feed and thick depth-of-cut. With regard to conventional coated carbide member, 1-TiCN layer that is constituent of conventional hard coating layer has fairly good toughness itself, consequently whole hard coating layer also shows sufficient toughness. So, it exhibits excellent cutting performance without any chipping at cutting edge when it is applied to high speed continuous cutting operations. Meanwhile, when it is applied to extremely severe cutting condition such as high speed, high feed and thick depth-of-cut interrupted cutting operations, chipping at cutting edge is by all means inevitable because of its insufficient toughness for these cutting operations, consequently the tool lifetime become shorter.

### SUMMARY OF THE INVENTION

Accordingly, one object of the present invention is to provide a coated carbide member that resists chipping of cutting edge over long periods of time even when it is applied to high speed, high feed, and thick depth-of-cut interrupted cutting operations of steels and cast irons.

Briefly, this object of the present invention as hereinafter will become more readily apparent can be attained by a coated carbide member for a cutting tool comprising a substrate and a hard coating layer on said substrate,
wherein the hard coating layer comprises (a) at least one titanium compound layer composed of at least one layer of granular titanium compound selected from TiC, TiN, TiCN, Ti₂O₃, TiCO, TiNO and TiCNO, (b) 1-TiCN layer having a compositional gradient of carbon (C) and nitrogen (N) along with its growth direction (gradient 1-TiCN), and (c) Al₂O₃ layer, wherein gradient l-TiCN is expressed by molecular formula TiCl-xNx, wherein x is the atomic ratio of N to the sum of C and N, and it ranges from 0.45 to 0.95 at top portion of said gradient 1-TiCN layer and ranges from 0.05 to 0.40 at bottom portion of that.

A further object of the present invention is to provide a process for producing a coated carbide member with gradient 1-TiCN layer by changing the gas concentration of the reactive gas concentration of CH3CN, CH4, and/or N2, and the deposition temperature, from 850-950°C for the bottom portion to 960-1040°C for the top portion, during the deposition period of 1-TiCN layer.

### DETAILED DESCRIPTION OF THE PREFERRED EMBODIMENT

The present invention provides a hard coating layer that is coated on the cutting member of a cutting tool. The term "cutting member" refers to the part of the cutting tool that actually cuts the work piece. Cutting members include exchangeable cutting inserts which are mounted on the bit holders of turning tools, face milling cutter bodies, and end-milling cutter bodies. Cutting members also include the cutting blade of drills and end-mills. The cutting member is preferably made of tungsten carbide-based cemented carbide substrates.

The hard coating layer preferably coats a portion of the surface, more preferably the entire surface of the cutting member. The hard coating layer is preferably comprise (a) at least one titanium compound layer composed of at least one layer of granular titanium compound selected from TiC, TiN, TiCN, Ti₂O₃, TiCO, TiNO and TiCNO, (b) 1-TiCN layer having a compositional gradient of C and N along with its growth direction, and expressed as TiC1-xNx, wherein x ranges from 0.45 to 0.95 at top portion, and it ranges from 0.05 to 0.40 at bottom portion, and (c) Al₂O₃ layer.

The preferred embodiments of the present invention were discovered after testing many different kinds of hard coating layers on cemented carbide cutting member from the standpoint of developing a new long lifetime coated carbide member whose hard coating layer has further improved toughness characteristics. From these tests, the following result (A) and (B) were found:
(A)Continuous or periodical changes of the gas concentration of the reactive gas component such as CH₃CN, CH4 and/or N₂during the deposition period of 1-TiCN layer gives 1-TiCN layer that has a compositional gradient of C and N along with its growth direction, the concentration of C decreased and that of N increased from bottom to top in that layer. This gradient 1-TiCN layer is expressed by molecular formula TiC 1-xNx, wherein x is the atomic ratio of N to the sum of C and N, and it ranges from 0.45 to 0.95 at top portion of said gradient 1-TiCN layer and ranges from 0.05 to 0.40 at bottom portion of it. In this case, the concentration gradient from bottom portion to top portion is varies, continuously or step by step, owing to its manufacturing gas condition.

Further, a manufacturing process in which the deposition temperature is changed from 850-950°C for the bottom portion to 960-1040°C for the top portion together with the change in gas concentration mentioned above gives a more favorable crystal structure of said gradient 1-TiCN layer.
(B) Said gradient 1-TiCN layer has excellent toughness compared to conventional 1-TiCN layer manufactured by CVD method at moderate temperature range such as 700 to 950°C without any compositional gradient in it. Therefore with regard to coated carbide member that include said gradient 1-TiCN layer as a constituent of hard coating layer, the hard coating layer itself become all the tougher by the effect of said tough gradient 1-TiCN layer, it gives fairly long tool lifetimes without any chipping at cutting edge even when it is applied to extremely severe cutting operations such as high speed, high feed, and thick depth-of-cut interrupted cutting of steels and cast irons.

Based on these results, the present invention provides for a coated carbide member that exhibits superior resistance against chipping at cutting edge for a long period of time even when it is applied to extremely severe cutting operations such as high speed, high feed, and thick depth-of-cut interrupted cutting of steels and cast irons, because of excellent toughness of the hard coating layer, by providing a coated carbide member preferably composed of a cemented carbide substrate and a hard coating layer preferably having an average thickness of 3 to 25 µm formed on the substrate by means of CVD and/or PVD method, and that comprise (a) at least one titanium compound layer having average thickness of 0.1 to 5µm and composed of at least one layer of granular titanium compound selected from TiC, TiN, TiCN, Ti₂O₃, TiCO, TiNO and TiCNO, (b) 1-TiCN layer that has compositional gradient of C and N along with its growth direction having average thickness of 2 to 15µm and expressed by molecular formula TiCl-xNx, wherein x is the atomic ratio of N to the sum of C and N, and it ranges from 0.45 to 0.95 at top portion and ranges from 0.05 to 0.40 at bottom portion, and (c) Al₂O₃ layer having average thickness of 0.5 to 8µm.

In the present invention, the average thickness of the hard coating layer is preferably 3 to 25 µm. Excellent wear resistance cannot be achieved at a thickness of less than 3 µm, whereas breakage and chipping at the cutting edge of the cutting member easily occur at a thickness of over 25 µm.

Individual Ti compound layers have a function to ensure sufficient adherence between different two layers. It becomes difficult to keep sufficient adherence at a thickness of less than 0.1 µm, whereas wear resistance decreases at a thickness of over 5 µm. So, the average thickness of individual Ti compound layers is set to 0.1 to 5 µm.

Al₂O₃ layer has a function to increase wear resistance of hard coating layer especially for high speed cutting operation because of its satisfactory properties such as thermal barrier and oxidation resistance. It becomes difficult to achieve enough wear resistance at a thickness of less than 0.5 µm, whereas chipping at cutting edge easily becomes to occur at a thickness of over 8 µm. So, the average thickness of Al₂O₃ layer is set to 0.5 to 8 µm.

Gradient 1-TiCN layer has a function to improve the toughness of hard coating layer as noted above. It becomes difficult to provide satisfactory properties of this layer at a thickness of less than 2 µm, whereas wear resistance of this layer decrease sharply at a thickness of over 15 µm. So, the average thickness of gradient 1-TiCN layer is set to 2 to 15 µm.

With regard to gradient 1-TiCN layer expressed as TiC1-xNx, when x value at top portion is less than 0.45 or that value at bottom portion is more than 0.40, the concentration gradient of C and N becomes rather small, consequently the sufficient improvement of layer toughness cannot be attained. Meanwhile, when x value at top portion is more than 0.95 or that value at bottom portion is less than 0.05, it becomes difficult to secure its longitudinal crystal structure, consequently the toughness of said layer decreases sharply, then chipping at cutting edge easily occur. So, the x value at top portion is set to 0.45 to 0.95, preferably to 0.50 to 0.75, and the x value at bottom portion is set to 0.05 to 0.40, preferably to 0.15 to 0.35.

Having generally described this invention, a further understanding can be obtained by reference to certain specific Examples that are provided herein for purposes of illustration only and are not intended to be limiting unless otherwise specified.

### EXAMPLES

### Example 1

The following powdered materials were prepared as raw materials for substrates: a WC powder with an average grain size of 1.5 µm or 3.0 µm, a (Ti,W)CN powder (TiC/TiN/WC=24/20/56) with an average grain size of 1.2 µm, a TaC/NbC powder (TaC/NbC=90/10) with an average grain size of 1.3 µm, a Cr₃C₂ powder with an average grain size of 1 µm, a VC powder with an average grain size of 1.2 µm and Co powder with an average grain size of 1.2 µm. Those powders were compounded based on the formulation shown in Table 1, wet-mixed in a ball mill for 72 hours and dried. Several dry powder mixtures were prepared in this manner and then each was pressed at a pressure of 1 ton/cm² to form green compacts, which were sintered under the following conditions; pressure: 0.001Torr, temperature: 1400 to 1460°C, holding duration: 1 hour, to manufacture cemented carbide insert substrates A through E defined in ISO-CNMG 120408.

The cutting edges of the cemented carbide insert substrates A through F were honed. Each substrate was subjected to chemical vapor deposition using conventional equipment under the conditions shown in Tables 2 and 3 to provide hard coating layers on the substrate. Individual coating layers shown in Table 2 has homogeneous composition from bottom to top of that layer, and every coating layers other than 1-TiCN in Table 2 has granular crystal structure. To manufacture coated cemented carbide inserts in accordance with the present invention and conventional, a hard coating layer was coated on each substrate, wherein the designed coating layer structure and thickness of each layer is shown in Tables 4, 5. Coated cemented carbide inserts in accordance with the present invention 1 through 10 and conventional coated carbide inserts 1 through 10 were manufactured in such a manner.

In Table 4, the description for example this invention 1 "1-TiCN (a) ~ 1-TiCN (2) [5 steps], (4.3)" means a gradient 1-TiCN layer of 4.3 µm of its aimed thickness which has prepared by following method, that is, bottom portion of said layer was manufactured using gas condition of 1-TiCN (a) in Table 3, top portion of said layer was manufactured using gas condition of 1-TiCN (2), and there were 5 steps of change in gas concentration of CH₃CN, CH₄ and/or N₂ during deposition of said layer. Likewise, the description for example this invention 2 "1-TiCN (b) ~ 1-TiCN (1) [continuous], (3.8)" means a gradient 1-TiCN layer of 3.8 µm of its aimed thickness which has prepared by following method, that is, bottom portion of said layer was manufactured using gas condition of 1-TiCN (b) in Table 3, top portion of said layer was manufactured using gas condition of 1-TiCN (1), and there was a continuous change in gas concentration of CH₃CN, and/or N₂ during deposition of said layer.

To investigate the x value at the portion both 0.2 µm from upper interface and 0.2 µm from lower surface of individual gradual 1-TiCN layer for coated cemented carbide in accordance with present invention 1 through 10, a cross-sectional analysis using Auger Electron Spectroscopy (AES) was performed and it was confirmed that x value of individual gradient 1-TiCN layer was almost identical to the designed value. From the investigation of the hard coating layers using optical microscope, the thickness of each layer was almost identical to designed thickness.

Further, for coated cemented carbide inserts of the present invention 1 through 10 and conventional coated cemented carbide inserts 1 through 10, the following interrupted cutting tests were conducted. The wear width on the flank face was measured in each test. The results are shown in Table 6.
(1-1) Cutting style: Interrupted turning of alloyed steel
   Work piece: JIS SCM440 round bar having 4 longitudinally grooves
   Cutting speed: 300 m/min
   Feed rate: 0.32 mm/rev
   Depth of cut: 5 mm
   Cutting time: 10 min
   Coolant: Dry
(1-2) Cutting style: Interrupted turning of alloyed steel
   Work piece: JIS SCM440 round bar having 4 longitudinally grooves
   Cutting speed: 300 m/min
   Feed rate: 0.6 mm/rev
   Depth of cut: 1.5 mm
   Cutting time: 10 min
   Coolant: Dry

**Table 1**

| Carbide substrate | Composition (wt%) | | | | | |
|---|---|---|---|---|---|---|
| | Co | (Ti,W)CN | (Ta,Nb)C | Cr₃C₂ | VC | WC |
| A | 6 | - | 2 | - | - | Balance (1.5 µm) |
| B | 6 | 6 | - | 0.1 | 0.2 | Balance (3.0 µm) |
| C | 7 | 7 | 5 | 0.4 | - | Balance (3.0 µm) |
| D | 8 | 5 | 4 | 0.4 | 0.2 | Balance (3.0 µm) |
| E | 10 | - | - | 0.1 | - | Balance (1.5 µm) |

| | | | | | | |
|---|---|---|---|---|---|---|
| WC:average grain size 1.5 µm or 3.0 µm | | | | | | |

**Table 2**

| Hard coating layer | Manufacturing conditions of hard coating layer | | |
|---|---|---|---|
| | Composition of reactive gas (volume %) | Ambience | |
| | | Pressure (Torr) | Temperature (°C) |
| TiC | TiCl₄ : 3%, CH₄ : 4%, H₂ : Balance | 50 | 1020 |
| TiN (1st layer) | TiCl₄ : 3%, N₂ : 40%, H₂ : Balance | 150 | 900 |
| TiN (others) | TiCl₄ 3%, N₂ : 45%, H₂ : Balance | 50 | 1040 |
| 1-TiCN | TiCl₄ : 3%, N₂ : 30%, CH₃CN : 1%, H₂ : Balance | 50 | 900 |
| TiCN | TiCl₄ 3%, N₂ : 6%, CH₄ : 2%, H₂ : Balance | 120 | 960 |
| Ti₂O₃ | TiCl₄ 3%, CO2 : 2%, H₂ : Balance | 100 | 1020 |
| TiCO | TiCl₄ 3%, CO : 2%, CH₄ : 2%, H₂ : Balance | 100 | 1000 |
| TiNO | TiCl₄ : 3%, N₂ : 30%, CO : 2%, H₂ : Balance | 120 | 1000 |
| TiCNO | TiCl₄: 3%, CO : 2%, CH₄ : 2%, N₂ : 30%, H₂ : Balance | 120 | 1000 |
| α-Al₂O₃ | AlCl₃: 5%, CO₂: 8%, HCl: 1.5%, H₂S: 0.5%, H₂: Balance | 50 | 1000 |
| κ-Al₂O₃ | AlCl₃: 5%, CO₂: 6%, HCl: 1.5%, H₂S: 0.3%, H₂: Balance | 50 | 950 |

**Table 3**

| l-TiC1-xNx layer | | Manufacturing conditions of gradient l-TiCN layer | | |
|---|---|---|---|---|
| | | Composition of reactive gas (volume %) | pressure(kPa) | temperature(°C) |
| upper portion | l-TiCN(1) (x : 0.45) | TiCl₄ : 2%, N₂ : 30%,CH₄ : 1%, CH₃CN : 0.6%, H₂ : Balance | 8.0 | 980 |
| | l-TiCN (2) (x : 0.55) | TiCl₄ : 2%, N₂ : 30%, CH₄ : 0.6%, CH₃CN : 0.4%, H₂ : Balance | 8.0 | 980 |
| | l-TiCN (3) (x : 0.65) | TiCl₄ : 2%, N₂ : 35%, CH₄ : 0.3%, CH₃CN : 0.4%, H₂ : Balance | 8.0 | 980 |
| | l-TiCN (4) (x : 0.75) | TiCl₄ : 2%, N₂ : 35%, CH₄ : 0.1%, CH₃CN : 0.2%, H₂ : Balance | 8.0 | 980 |
| | l-TiCN (5) (x : 0.85) | TiCl₄ : 2%, N₂ : 40%, CH₃CN : 0.2%, H₂ : Balance | 8.0 | 980 |
| | l-TiCN (6) (x : 0.95) | TiCl₄ : 2%, N₂ : 46%, CH₃CN : 0.05%, H₂ : Balance | 8.0 | 980 |
| lower portion | l-TiCN (a) (x : 0.05) | TiCl₄ : 2%, CH₄ : 3%, CH₃CN : 0.2%, H₂ : Balance | 8.0 | 930 |
| | l-TiCN (b) (x : 0.10) | TiCl₄ : 2%, CH₄ : 2%, CH₃CN : 0.4%, H₂ : Balance | 8.0 | 930 |
| | l-TiCN (d) (x : 0.20) | TiCl₄ : 2%, N₂ : 5%, CH₄ : 1%, CH₃CN : 1%, H₂ : Balance | 8.0 | 930 |
| | l-TiCN (f) (x : 0.30) | TiCl₄ : 2%, N₂ : 5%, CH₃CN : 1%, H₂ : Balance | 8.0 | 930 |
| | l-TiCN (g) (x : 0.35) | TiCl₄ : 2%, N₂ : 10%, CH₃CN : 1%, H₂ : Balance | 8.0 | 930 |
| | l-TiCN (g) (x : 0.40) | TiCl₄: 2%, N₂ : 10%, CH₃CN : 0.8%, H₂ : Balance | 8.0 | 930 |

**Table 4**

| Insert | | Substrate | Hard coating layer (Figure in parenthesis means designed thickness ; m) | | | | | |
|---|---|---|---|---|---|---|---|---|
| | | | First layer | Second layer | Third layer | Forth layer | Fifth layer | Sixth layer |
| This invention | 1 | A | TiN (0.3) | TiCN (1.5) | l-TiCN (a) ~ l-TiCN (2) [5 steps], (4.3) | α -Al₂O₃ (0.6) | TiN (0.3) | - |
| | 2 | B | TiC (0.4) | TiN (0.7) | l-TiCN(b) ~ l-TiCN (1) [continuous], (3.8) | TiCO (0.5) | κ -Al₂O₃ (7.8) | - |
| | 3 | B | TiN (0.5) | l-TiCN (c) ~ l-TiCN (5) [3 steps], (4.0) | TiCNO (0.6) | α -Al₂O₃ (1.8) | TiN (0.4) | - |
| | 4 | C | TiC(0.5) | l-TiCN (c) ~ I-TiCN (3) [continuous], (7.2) | TiC(1.5) | κ -Al₂O₃ (3.7) | *α* -Al₂O₃ (2.4) | TiN (0.5) |
| | 5 | C | TiN (0.5) | l-TiCN(d) ~ l-TiCN (4) [15 steps], (9.4) | TiCN (0.6) | TiCN (3.6) | κ-Al₂O₃ (2.2) | TiN (0.4) |
| | 6 | D | TiN (0.9) | l-TiCN (d) ~ l-TiCN (3) [2 steps], (8.5) | TiC (0.5) | TiCNO (0.3) | α -Al₂O₃(2.6) | - |
| | 7 | D | TiN (0.6) | l-TiCN (e) ~ l-TiCN (2) [continuous], (2.1) | TiC (2.7) | TiCNO (0.5) | α-Al₂O₃(1.4) | TiN (0.4) |
| | 8 | E | l-TICN (c) ~l-TiCN (4) [continuous], (6.6) | l-TiCN (e) ~ l-TiCN (4) [continuous], (6.6) | Ti₂O₃ (0.5) | κ -Al₂O₃ (3.2) | TiCO (0.2) | TiN (0.4) |
| | 9 | E | TiC (1.0) | l-TiCN (f) ~ l-TiCN (5) [10 steps], (12.0) | α-Al₂O₃ (1.6) | TiCO (0.2) | TiCO (0.2) | - |
| | 10 | F | TiC (1.2) | TiCNO (0.7) | l-TICN (f)~l-TiCN (6) [continuous],(14.5) | TiNO (0.5) | α-Al₂O₃ (3.4) | κ-Al₂O₃(2.9) |

**Table 5**

| Insert | | Substrate | Hard coating layer (Figure in parenthesis means designed thickness; µ m) | | | | | |
|---|---|---|---|---|---|---|---|---|
| | | | First layer | Second layer | Third layer | Forth layer | Fifth layer | Sixth layer |
| Conventional | 1 | A | TiN (0.3) | TiCN (1.5) | l-TiCN (4.3) | α -Al₂O₃ (0.6) | TiN (0.3) | - |
| | 2 | B | TiC (0.4) | TiN (0.7) | l-TiCN (3.8) | TiCO (0.5) | κ -Al₂O₃ (7.9) | - |
| | 3 | B | TiN (0.5) | l-TiCN (4.0) | TiCNO (0.6) | α -Al₂O₃ (1.8) | TiN (0.4) | - |
| | 4 | C | TiC (0.5) | l-TiCN (7.2) | TiC (1.5) | κ -Al₂O₃) (3.7) | α-Al₂O₃ (2.4) | TiN (0.5) |
| | 5 | C | TiN (0.5) | l-TiCN (9.4) | TiN (0.6) | TiCN (3.6) | κ -Al₂O₃) (2.2) | TiN (0.4) |
| | 6 | D | TiN (0.9) | l-TiCN (8.5) | TiC (0.5) | TiCNO (0.3) | α -Al₂O₃ (2.6) | - |
| | 7 | D | TiN (0.6) | l-TiCN (2.1) | TiC (2.7) | TiCNO (0.5) | α -Al₂O₃ (1.4) | TiN (0.4) |
| | 8 | E | I:TiCN (6.6) | TiC (3.5) | Ti₂O₃ (0.5) | κ -Al₂O₃ (3.2) | TiC (0.2) | TiN (0.3) |
| | 9 | E | TiC (1.0) | l-TiCN (12.0) | α -Al₂O₃ (1.6) | TiCO (0.2) | TiN (0.4) | - |
| | 10 | F | TiC (1.2) | TiCNO(0.7) | l-TiCN(14.5) | TiNO(0.5) | α -Al₂O₃(3.4) | κ -Al₂O₃(2.9) |

**Table 6**

| Insert | | Flank wear (mm) | | Insert | | Flank wear (mm) | |
|---|---|---|---|---|---|---|---|
| | | high speed and thick depth-of-cut | high speed and high feed | | | high speed and thick depth-of-cut | high speed and high feed |
| This invention | 1 | 0.23 | 0.25 | Conventional | 1 | Failure at 1 min. | Failure at 1 min. |
| | 2 | 0.25 | 0.28 | | 2 | Failure at 1.5 min. | Failure at 2 min. |
| | 3 | 0.22 | 0.21 | | 3 | Failure at 2.5 min. | Failure at 2 min. |
| | 4 | 0.18 | 0.19 | | 4 | Failure at 3 min. | Failure at 2.5 min. |
| | 5 | 0.14 | 0.15 | | 5 | Failure at 3.5 min. | Failure at 3 min. |
| | 6 | 0.15 | 0.14 | | 6 | Failure at 3min. | Failure at 3.5 min. |
| | 7 | 0.20 | 0.21 | | 7 | Failure at 1 min. | Failure at 1 min. |
| | 8 | 0.18 | 0.18 | | 8 | Failure at 2.5min. | Failure at 3 min. |
| | 9 | 0.25 | 0.27 | | 9 | Failure at 2 min. | Failure at 1.5 min. |
| | 10 | 0.28 | 0.30 | | 10 | Failure at 0.5 min. | Failure at 1.5 min. |

| | | | | | | | |
|---|---|---|---|---|---|---|---|
| All failures were caused by chipping occurred at cutting edge | | | | | | | |

## Claims

1. A coated cemented carbide cutting tool member comprising a substrate and a hard coating layer deposited on said substrate by chemical vapor deposition and/or physical vapor deposition,
wherein said hard coating layer has an average thickness of 3 to 25 µm, and comprises (1) at least one Ti compounds layer that is composed of at least one granular layer of TiC, TiN, TiCN, Ti₂O₃, TiCO, TiNO and TiCNO, whose average thickness is 0.1 to 5 µm, (2) a TiCN layer having longitudinal growth crystal structure whose average thickness is 2 to 15 µm, and (3) a Al₂O₃ layer whose average thickness is 0.5 to 8 µm,
wherein said longitudinal TiCN layer has a compositional gradient of carbon and nitrogen along with its growth direction and, when the composition of said longitudinal TiCN layer is expressed as TiC₁₋ₓNₓ, the x value at top portion of said longitudinal TiCN layer is in the range of 0.45 to 0.95, and the x value at bottom portion of said layer is in the range of 0.05 to 0.40.

2. The coated cemented carbide cutting tool member according to claim 1, wherein the compositional gradient in said longitudinal TiCN layer varies step-by-step.

3. The coated cemented carbide cutting tool member according to claim 1, wherein the compositional gradient in said longitudinal TiCN layer is continuous.

4. A process for producing the coated carbide member comprising a longitudinal growth TiCN layer with a compositional gradient according to claim 1, 2, and 3, the process comprising changing the reactive gas concentration of CH₃CN, CH₄, and/or N₂, and the deposition temperature from 850-950°C for the bottom portion to 960-1040°C for the top portion, during the deposition period of longitudinal TiCN layer.

5. The process according to claim 4, wherein the reactive gas concentration of CH₃CN, CH₄ and/or N₂, and the deposition temperature are changed step by step during the deposition period of longitudinal TiCN layer.

6. The process according to claim 4, wherein the reactive gas concentration of CH₃CN, CH₄, and/or N₂, and the deposition temperature are changed continuously during the deposition period of longitudinal TiCN layer.

## Patentansprüche

1. Beschichtetes Sinterkarbid-Schneidwerkzeugelement, das ein Substrat und eine harte Überzugsschicht umfaßt, die auf dem Substrat durch chemische Gasphasenabscheidung und/oder physikalische Gasphasenabscheidung aufgebracht ist,
worin die harte Überzugsschicht eine durchschnittliche Dicke von 3 bis 25 µm hat und (1) wenigstens eine Schicht mit Ti-Verbindungen, die aus wenigstens einer körnigen Schicht von TiC, TiN, TiCN, Ti₂O₃, TiCO, TiNO und TiCNO zusammengesetzt ist, deren durchschnittliche Dicke 0,1 bis 5 µm ist, (2) eine TiCN-Schicht mit einer Kristallstruktur mit Längswachstum, deren durchschnittliche Dicke 2 bis 15 µm ist, und (3) eine Al₂O₃-Schicht umfaßt, deren durchschnittliche Dicke 0,5 bis 8 µm ist,
worin die längslaufende TiCN-Schicht einen Zusammensetzungsgradienten von Kohlenstoff und Stickstoff entlang ihrer Wachstumsrichtung hat und, wenn die Zusammensetzung der längslaufenden TiCN-Schicht als TiC₁₋ₓNₓ ausgedrückt wird, der x-Wert des Deckteils der längslaufenden TiCN-Schicht im Bereich von 0,45 bis 0,95 und der x-Wert des Bodenteils der Schicht im Bereich von 0,05 bis 0,40 ist.

2. Beschichtetes Sinterkarbid-Schneidwerkzeugelement gemäß Anspruch 1, worin der Zusammensetzungsgradient in der längslaufenden TiCN-Schicht sich Schritt für Schritt ändert.

3. Beschichtetes Sinterkarbid-Schneidwerkzeugelement gemäß Anspruch 1, worin der Zusammensetzungsgradient in der längslaufenden TiCN-Schicht kontinuierlich ist.

4. Verfahren zur Herstellung des beschichteten Karbidelements, das eine TiCN-Schicht mit Längswachstum mit einem Zusammensetzungsgradienten gemäß Anspruch 1, 2 und 3 umfaßt, wobei das Verfahren das Verändern der reaktiven Gaskonzentration von CH₃CN, CH₄ und/oder N₂ und der Abscheidungstemperatur von 850-950°C für den Bodenteil bis 960-1.040°C für den Deckteil während der Abscheidungsdauer der längslaufenden TiCN-Schicht umfaßt.

5. Verfahren gemäß Anspruch 4, worin die reaktive Gaskonzentration von CH₃CN, CH₄ und/oder N₂ und die Abscheidungstemperatur Schritt für Schritt während der Abscheidungsdauer der längslaufenden TiCN-Schicht verändert werden.

6. Verfahren gemäß Anspruch 4, worin die reaktive Gaskonzentration von CH₃CN, CH₄ und/oder N₂ und die Abscheidungstemperatur kontinuierlich während der Abscheidungsdauer der längslaufenden TiCN-Schicht verändert werden.

## Revendications

1. Outil de coupe en carbure cémenté muni d'un revêtement comprenant un substrat et une couche de revêtement dur déposée sur ledit substrat par un dépôt chimique en phase vapeur et/ou un dépôt physique en phase vapeur,
dans lequel ladite couche de revêtement dur possède une épaisseur moyenne de 3 à 25 µm, et comprend (1) au moins une couche de composés de Ti qui est composée d'au moins une couche granulaire de TiC, TiN, TiCN, Ti₂O₃, TiCO, TiNO et TiCNO, dont l'épaisseur moyenne est de 0,1 à 5 µm, (2) une couche de TiCN ayant une structure cristalline à croissance longitudinale dont l'épaisseur moyenne est de 2 à 15 µm, et (3) une couche de Al₂O₃ dont l'épaisseur moyenne est de 0,5 à 8 µm,
dans lequel ladite couche de TiCN longitudinale possède un gradient de composition de carbone et d'azote le long de sa direction de croissance, et, lorsque la composition de ladite couche de TiCN longitudinale est exprimée par TiC₁-ₓNₓ, la valeur x au niveau de la partie supérieure de ladite couche de TiCN longitudinale est de l'ordre de 0,45 à 0,95, et la valeur x au niveau de la partie inférieure de ladite couche est de l'ordre de 0,05 à 0,40.

2. Outil de coupe en carbure cémenté muni d'un revêtement selon la revendication 1, dans lequel le gradient de composition dans ladite couche de TiCN longitudinale varie étape par étape.

3. Outil de coupe en carbure cémenté muni d'un revêtement selon la revendication 1, dans lequel le gradient de composition dans ladite couche de TiCN longitudinale est continu.

4. Processus de production de l'élément en carbure muni d'un revêtement comprenant une couche de TiCN à croissance longitudinale ayant un gradient de composition selon la revendication 1, 2 et 3, le processus comprenant le changement de la concentration en gaz réactif CH₃CN, CH₄ et/ou N₂, et de la température de dépôt de 850 à 950°C pour la partie inférieure à 960 à 1040°C pour la partie supérieure pendant la période de dépôt de la couche de TiCN longitudinale.

5. Processus selon la revendication 4, dans lequel la concentration en gaz réactif CH₃CN, CH₄ et/ou N₂ et la température de dépôt sont changées étape par étape pendant la période de dépôt de la couche de TiCN longitudinale.

6. Processus selon la revendication 4, dans lequel la concentration en gaz réactif CH₃CN, CH₄ et/ou N₂ et la température de dépôt sont changées en continu pendant la période de dépôt de la couche de TiCN longitudinale.
